# EUROPEAN PATENT APPLICATION

(11) **EP 4 697 046 A1**
(43) Date of publication of application: **18.02.2026**
(21) Application number: 24819478.9
(22) Date of filing: 29.04.2024
(51) Int. Cl.: G01R 31/396, G01R 31/392, G01R 31/385, G01R 31/382, H01M 10/48, G08B 21/18, H02J 7/00, B60R 16/033

(54) **BATTERY DIAGNOSIS APPARATUS AND OPERATING METHOD THEREOF**

(30) Priority: 09.06.2023 KR 20230074245
(71) Applicant: LG Energy Solution, Ltd., Seoul 07335 (KR)
(72) Inventor: LEE, Da Jin, Daejeon 34122 (KR); CHO, In Hwan, Daejeon 34122 (KR); PARK, Heung Il, Daejeon 34122 (KR); SEO, Jung Oh, Daejeon 34122 (KR); KANG, Ju Young, Daejeon 34122 (KR)
(74) Representative: Goddar, Heinz J.
(86) International application number: PCT/KR2024/005744
(87) International publication number: WO 2024/253326

(57) **Abstract**

A battery diagnosis apparatus according to an embodiment disclosed herein includes a charging/discharging unit configured to charge/discharge a battery in a constant current (CC) mode or a constant voltage (CV) mode, an information obtaining unit configured to measure a voltage or a temperature of the battery, and a controller configured to diagnose a state of the battery based on at least one of a change range of the voltage for a preset time or a temperature variance from a switching point of a charging mode.

## Description

### [Technical Field]

### CROSS-REFERENCE TO RELATED APPLICATION

This application claims priority to and the benefit of Korean Patent Application No. 10-2023-0074245 filed in the Korean Intellectual Property Office on June 9, 2023, the entire content of which is incorporated herein by reference.

### TECHNICAL FIELD

Embodiments disclosed herein relate to a battery diagnosis apparatus and an operating method thereof.

### [Background Art]

Current commercially available batteries include nickel cadmium batteries, nickel hydride batteries, nickel zinc batteries, lithium-ion batteries, and so forth, among which the lithium batteries are in the limelight due to their advantages of free charge and discharge due to little memory effect, very low self-discharge rate, and high energy density, compared to nickel-based batteries.

The lithium-ion battery is a secondary battery that includes a positive electrode, a negative electrode, an electrolyte, and a separator, and is chargeable and dischargeable according to movement of lithium ions between the positive electrode and the negative electrode through the electrolyte.

When such a battery ignites during the use thereof, a serious accident may occur due to reaction between chemical substances inside the battery. To prevent such an accident, a technique has been developed to diagnose the state of the battery by observing whether a voltage of the battery exceeds a preset voltage. However, existing techniques for predicting the ignition of the battery may have a limitation in guaranteeing the accuracy and reliability of the prediction.

### [Disclosure]

### [Technical Problem]

Embodiments disclosed herein aim to provide a battery diagnosis apparatus and an operating method thereof in which the ignition of a battery may be sensed in advance based on a voltage, a temperature, or a current of the battery.

Technical problems of the embodiments disclosed herein are not limited to the above-described technical problems, and other unmentioned technical problems would be clearly understood by those skilled in the art in the technical field to which the present disclosure pertains from the following description.

### [Technical Solution]

A battery diagnosis apparatus according to an embodiment disclosed herein includes a charging/discharging unit configured to charge/discharge a battery in a constant current (CC) mode or a constant voltage (CV) mode, an information obtaining unit configured to measure a voltage or a temperature of the battery, and a controller configured to diagnose a state of the battery based on at least one of a change range of the voltage for a preset time or a temperature variance from a switching point of a charging mode.

According to an embodiment, the controller may be further configured to, in the CV mode, calculate the voltage change range for the preset time and determine the state of the battery based on the change range.

According to an embodiment, the controller may be further configured to determine the state of the battery as abnormal when the change range falls within a preset range, and the change range may be a difference between a maximum value and a minimum value of the voltage.

According to an embodiment, the preset range may be set based on specifications of the charging/discharging unit.

According to an embodiment, the preset time may be set based on the specifications of the charging/discharging unit.

According to an embodiment, the controller may be further configured to compare a reference temperature, which is a temperature at a switching point from the CC mode to the CV mode, with a temperature of the battery and determine the state of the battery as abnormal when a difference between the temperature of the battery and the reference temperature is greater than or equal to a first reference value.

According to an embodiment, the controller may be further configured to determine the state of the battery as abnormal when the difference between the temperature of the battery and the reference temperature is greater than or equal to a second reference value and a current of the battery rises, and the second reference value may be less than the first reference value.

According to an embodiment, the information obtaining unit may be further configured to measure the current of the battery, and the controller may be further configured to determine whether the current falls out of a preset range and determine the state of the battery as abnormal when the current falls out of the preset range.

According to an embodiment, the controller may be further configured to transmit a notification to a user when the state of the battery is abnormal.

A battery diagnosis method according to an embodiment disclosed herein includes charging/discharging a battery in a constant current (CC) mode or a constant voltage (CV) mode, measuring a voltage, a current, or a temperature of the battery, and diagnosing a state of the battery based on at least one of a change range of the voltage for a preset time or a temperature variance from a switching point of a charging mode.

According to an embodiment, the diagnosing of the state of the battery may include calculating the voltage change range for the preset time in the CV mode and determining the state of the battery based on the change range.

According to an embodiment, the diagnosing of the state of the battery may include determining the state of the battery as abnormal when the change range falls within a preset range, and the change range may be a difference between a maximum value and a minimum value of the voltage.

According to an embodiment, the preset range may be set based on specifications of a charging/discharging unit.

According to an embodiment, the preset time may be set based on the specifications of the charging/discharging unit.

According to an embodiment, the diagnosing of the state of the battery may include comparing a reference temperature, which is a temperature at a switching point from the CC mode to the CV mode, with a temperature of the battery and determining the state of the battery as abnormal when a difference between the temperature of the battery and the reference temperature is greater than or equal to a first reference value.

According to an embodiment, the diagnosing of the state of the battery may include determining the state of the battery as abnormal when the difference between the temperature of the battery and the reference temperature is greater than or equal to a second reference value and a current of the battery rises, and the second reference value may be less than the first reference value.

According to an embodiment, the diagnosing of the state of the battery may include determining whether the current falls out of a preset range and determining the state of the battery as abnormal when the current falls out of the preset range.

According to an embodiment, the battery diagnosis method may further include, after diagnosing the state of the battery, transmitting a notification to a user when the state of the battery is abnormal.

Detailed matters of other embodiments are included in a detailed description and drawings.

### [Advantageous Effects]

The battery diagnosis apparatus and the operating method thereof according to embodiments disclosed herein may diagnose a state of a battery based on a voltage, a temperature, or a current of the battery in a constant voltage (CV) mode.

The effects of the battery diagnosis apparatus and the operating method thereof according to the disclosure of the present document are not limited to the effects mentioned above, and other effects not mentioned will be clearly understood by those of ordinary skill in the art according to the disclosure of the present document.

### [Description of Drawings]

FIG. 1 is a block diagram of a battery pack according to an embodiment disclosed herein.
FIG. 2 is a block diagram of a battery diagnosis apparatus according to an embodiment disclosed herein.
FIG. 3 is a graph showing a method, performed by a battery diagnosis apparatus, of diagnosing a state of a battery based on a change range of a voltage, according to an embodiment disclosed herein.
FIG. 4 is a graph showing a method, performed by a battery diagnosis apparatus, of diagnosing a state of a battery based on a temperature variance, according to an embodiment disclosed herein.
FIG. 5 is a graph showing a method, performed by a battery diagnosis apparatus, of diagnosing a state of a battery based on a current, according to an embodiment disclosed herein.
FIG. 6 is a flowchart of a battery diagnosis method according to an embodiment disclosed herein.
FIG. 7 is a flowchart showing in detail an operation of diagnosing a state of a battery in FIG. 6.
FIG. 8 is a block diagram illustrating a computing system that performs a battery diagnosis method according to an embodiment disclosed herein.

With regard to the description of the drawings, similar reference numerals may be used to refer to similar or related components.

### [Mode for Invention]

Hereinafter, embodiments of the present disclosure will be described with reference to the accompanying drawings. However, the description is not intended to limit the present disclosure to particular embodiments, and it should be construed as including various modifications, equivalents, and/or alternatives according to the embodiments of the present disclosure.

It should be appreciated that embodiments of the present document and the terms used therein are not intended to limit the technological features set forth herein to a particular embodiment and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise.

As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. Such terms as "1^{st}", "2^{nd}," "first", "second", "A", "B", "(a)", or "(b)" may be used to simply distinguish a corresponding component from another, and does not limit the components in other aspect (e.g., importance or order), unless mentioned otherwise.

Herein, it is to be understood that when an element (e.g., a first element) is referred to, with or without the term "operatively" or "communicatively", as "connected with", "coupled with", or "linked with", or "coupled to" or "connected to" to another element (e.g., a second element), it means that the element may be connected with the other element directly (e.g., wiredly or wirelessly), or indirectly (e.g., via a third element).

A method according to various embodiments disclosed herein may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store, or between two user devices directly. If distributed online, at least part of the computer program product may be temporarily generated or at least temporarily stored in the machine-readable storage medium, such as memory of the manufacturer's server, a server of the application store, or a relay server.

According to embodiments disclosed herein, each component (e.g., a module or a program) of the above-described components may include a single entity or multiple entities, and some of the multiple entities may be separately disposed in different components. According to various embodiments disclosed herein, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to embodiments disclosed herein, operations performed by the module, the program, or another component may be carried out sequentially, in parallel, repeatedly, or heuristically, or one or more of the operations may be executed in a different order or omitted, or one or more other operations may be added.

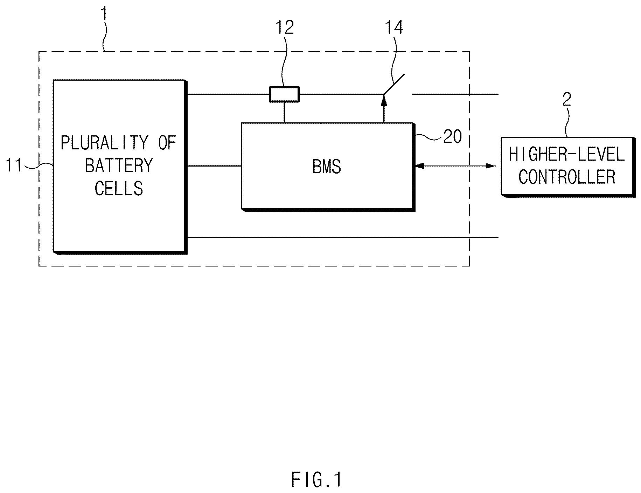

FIG. 1 is a block diagram of a battery pack according to an embodiment disclosed herein.

Referring to FIG. 1, a battery control system including a battery pack 1 and a higher-level controller 2 included in a higher-level system according to an embodiment disclosed herein is schematically shown.

As shown in FIG. 1, the battery pack 1 may include one or more battery cells 11, a switching unit 14 serially connected to a first terminal side and/or a second terminal side of the battery cell 11 to control a charging/discharging current flow of the battery cell 11, and a battery management system 20 for management to prevent over-charging and over-discharging by monitoring a voltage, a current, a temperature, etc., of the battery pack 1.

In this case, the battery pack 1 may include the battery cell 11, the sensor 12, the switching unit 14, and the battery management system 20 provided in plural. For example, the first terminal may be a positive (+) terminal of the battery cell 11, and the second terminal may be a negative (-) terminal.

Herein, as the switching unit 14 which is an element for controlling a current flow for charging or discharging of the plurality of battery cells 11, for example, at least one relay, magnetic contactor, etc., may be used according to specifications of the battery pack 1.

The battery management system 20, which is an interface for receiving measurement values of the above-described various parameter values, may include a plurality of terminals and a circuit, etc., connected thereto to process input values. The battery management system 20 may control on/off of the switching unit 14, e.g., a relay, a contactor, etc., and may be connected to the battery cell 11 to monitor the state of each battery cell 11.

The higher-level controller 2 may transmit a control signal regarding the battery cell 11 to the battery management system 20. Thus, the battery management system 20 may also be controlled in terms of an operation thereof based on a signal applied from the higher-level controller 2.

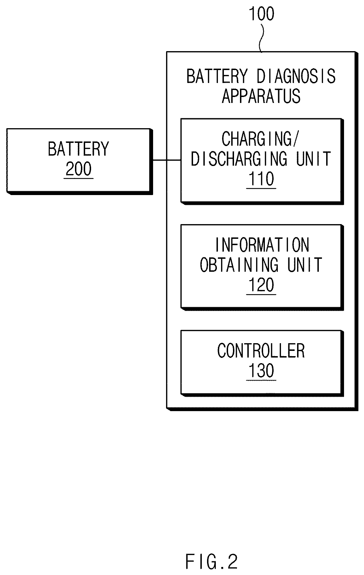

According to an embodiment, the battery management system 20 may include a battery diagnosis apparatus 100 of FIG. 2. According to another embodiment, the battery management system 20 may be different from the battery diagnosis apparatus 100 of FIG. 2. That is, the battery diagnosis apparatus 100 of FIG. 2 may be included in the battery pack 1 and may be configured as another device outside the battery pack 1. Hereinbelow, for convenience of description, it is assumed that the battery diagnosis apparatus 100 includes another device outside the battery pack 1, without being limited thereto. For example, the following operation of the battery diagnosis apparatus 100 may also be performed in various devices such as not only a battery management system (BMS) in a vehicle, but also a server, a cloud, a charger, a charger/discharger, etc.

FIG. 2 is a block diagram of a battery diagnosis apparatus according to an embodiment disclosed herein.

Referring to FIG. 2, the battery diagnosis apparatus 100 may include a charging/discharging unit 110, an information obtaining unit 120, and a controller 130.

The charging/discharging unit 110 may charge/discharge the battery 200. According to an embodiment, the charging/discharging unit 110 may charge/discharge the battery 200 in a plurality of modes. For example, the charging/discharging unit 110 may charge/discharge the battery 200 in a constant current (CC) mode or a constant voltage (CV) mode. Herein, the CC mode may be a constant current mode. The CV mode may be a constant voltage mode.

According to an embodiment, the charging/discharging unit 110 may charge/discharge the battery 200 in the CV mode after charging/discharging the battery 200 in the CC mode. That is, the charging/discharging unit 110 may charge/discharge the battery 200 in the CC mode and change a charging/discharging mode from the CC mode to the CV mode. In this case, a point in time at which the CC mode ends may coincide with a point in time at which the CV mode starts.

The information obtaining unit 120 may obtain information about the battery 200. According to an embodiment, the information obtaining unit 120 may obtain a voltage, a temperature, or a current of the battery 200. According to an embodiment, the information obtaining unit 120 may be connected to the battery 200.

The controller 130 may diagnose the state of the battery 200. The controller 130 may diagnose the state of the battery 200 based on the voltage, the temperature, or the current of the battery 200, obtained by the information obtaining unit 120. The controller 130 may determine the state of the battery 200 based on whether a change range of the voltage falls within a preset range in the CV mode. The controller 130 may determine the state of the battery 200 based on whether a difference between the temperature of the battery 200 and a preset temperature is greater than or equal to a first reference value in the CV mode. The controller 130 may also determine the state of the battery 200 based on whether a current of the battery 200 falls out of a preset range. That is, the controller 130 may determine the state of the battery 200 as normal or abnormal based on the voltage, the temperature, or the current of the battery 200. Herein, the battery 200 in an abnormal state may mean the battery 200 having a possibility of ignition.

The controller 130 may transmit a notification to a user. When the controller 130 determines the state of the battery 200 as abnormal, the controller 130 may provide information about the battery 200 to the user. According to an embodiment, the controller 130 may provide the information about the battery 200 to the user terminal through a communication unit (not shown) and provide the information about the battery 200 through a display provided in a vehicle, a charger, etc.

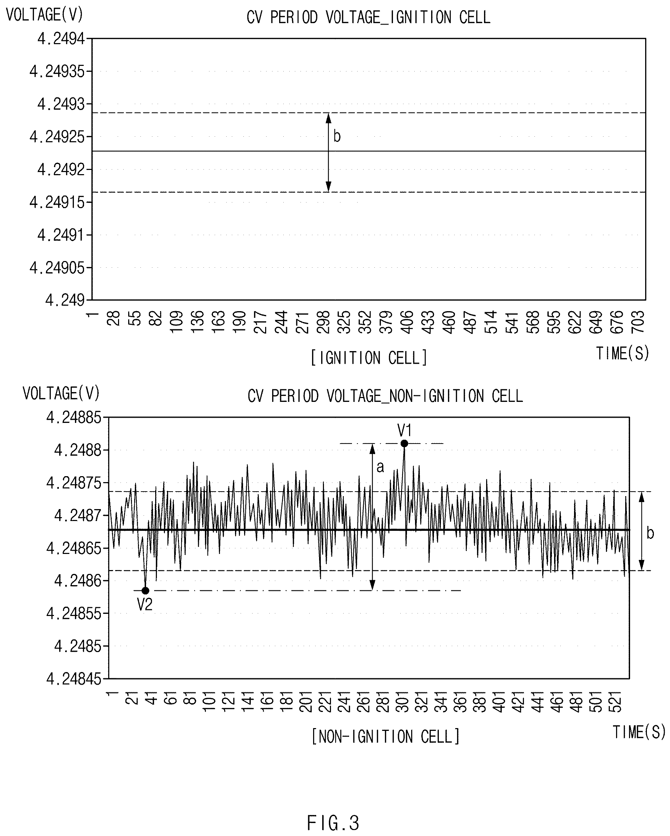

FIG. 3 is a graph showing a method, performed by a battery diagnosis apparatus, of diagnosing a state of a battery based on a change range of a voltage, according to an embodiment disclosed herein.

Referring to FIG. 3, the controller 130 may diagnose the state of the battery 200 based on the voltage of the battery 200. According to an embodiment, the controller 130 may diagnose the state of the battery 200, based on a change range a of the voltage. Specifically, the controller 130 may diagnose the state of the battery 200 based on a result of comparing the change range a of the voltage with a preset range b in the CV mode.

The controller 130 may calculate the change range a of the voltage for a preset time in the CV mode. Herein, the preset time may be set based on specifications of the charging/discharging unit 110. For example, when the precision of a voltage or a current applied by the charging/discharging unit 110 to charge the battery 200 is relatively high, the preset time may be set relatively long. When the precision of the voltage or the current applied by the charging/discharging unit 110 to charge the battery 200 is relatively low, the preset time may be set relatively short. The controller 130 may detect a maximum value V1 and a minimum value V2 of a voltage in the preset time. The controller 130 may calculate a difference between the maximum value V1 and the minimum value V2 of the voltage to calculate the change range a of the voltage.

The controller 130 may compare the change range a of the voltage with the preset range b. The controller 130 may determine the state of the battery 200 when the change range a of the voltage falls within the preset range b. The controller 130 may determine the state of the battery 200 as normal when the change range a of the voltage falls out of the preset range b. Herein, the preset range b may be set based on the specifications of the charging/discharging unit 110. For example, when the precision of a voltage or a current applied by the charging/discharging unit 110 to charge the battery 200 is relatively high, the preset range b may be set relatively narrow. When the precision of a voltage or a current applied by the charging/discharging unit 110 to charge the battery 200 is relatively low, the preset range b may be set relatively broad According to an embodiment, the width of the preset range b may be, but not limited to, 0.00001 V or less.

According to the precision of the voltage or the current of the charging/discharging unit 110 that charges/discharges the battery 200, the voltage applied to the battery 200 by the charging/discharging unit 100 in the CV mode may change. Thus, for the battery 200 in the normal state, the voltage of the battery 200 may also change corresponding to the voltage applied by the charging/discharging unit 110. On the other hand, for the battery 200 in the abnormal state, the change range a of the voltage of the battery 200 may be relatively narrow in spite of a change in the voltage applied by the charging/discharging unit 110.

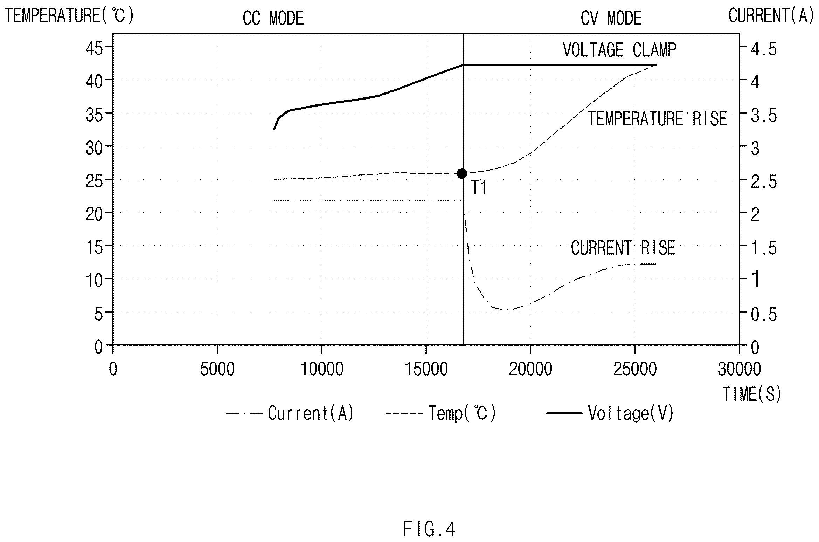

FIG. 4 is a graph showing a method, performed by a battery diagnosis apparatus, of diagnosing a state of a battery based on a temperature variance, according to an embodiment disclosed herein.

Referring to FIG. 4, the controller 130 may diagnose the state of the battery 200 based on the temperature of the battery 200. According to an embodiment, the controller 130 may diagnose the state of the battery 200 based on a temperature variance of the battery 200. Specifically, the controller 130 may diagnose the state of the battery 200 by comparing the temperature variance of the battery 200 with a reference value.

The controller 130 may set a reference temperature T1. Herein, the reference temperature T1 may be a temperature of the battery 200 at a point in time when the charging mode of the battery 200 switches from the CC mode to the CV mode. That is, the controller 130 may set the temperature of the battery 200 to the reference temperature T1 at a start point of the CV mode.

According to an embodiment, the controller 130 may calculate a difference between the temperature of the battery 200 and the reference temperature T1. The controller 130 may also compare the difference between the temperature of the battery 200 and the reference temperature T1 with a first reference value. Herein, the first reference value may be set based on a type of the battery 200, etc.

When the difference between the temperature of the battery 200 and the preset temperature T1 is greater than or equal to the first reference value, the controller 130 may determine the state of the battery 200 as abnormal. When the difference between the temperature of the battery 200 and the preset temperature T1 is less than the first reference value, the controller 130 may determine the state of the battery 200 as normal. In the CV charging mode, generally, the current of the battery 200 decreases and the voltage is constant, such that the temperature of the battery 200 may be maintained within a specific range. Thus, a battery undergoing a significant change in temperature from a switching point of the charging mode as charge continues may be an abnormal battery.

According to an embodiment, the controller 130 may diagnose the state of the battery 200 based on the temperature and the current of the battery 200. That is, the controller 130 may diagnose the state of the battery 200 by considering the temperature of the battery 200 and the current of the battery 200 together. For example, when the difference between the temperature of the battery 200 and the preset temperature T1 is greater than or equal to a second reference value and the current of the battery 200 rises, the controller 130 may determine the state of the battery 200 as abnormal. When the difference between the temperature of the battery 200 and the preset temperature T1 is less than the second reference value or the current of the battery 200 does not increase, the controller 130 may determine the state of the battery 200 as normal. Herein, the second reference value may be less than the first reference value. That is, as it takes time for the temperature of the battery 200 to rise, when the controller 130 considers both the temperature of the battery 200 and the current of the battery 200 together, the speed of battery diagnosis may be improved in comparison to when only the temperature of the battery 200 is considered.

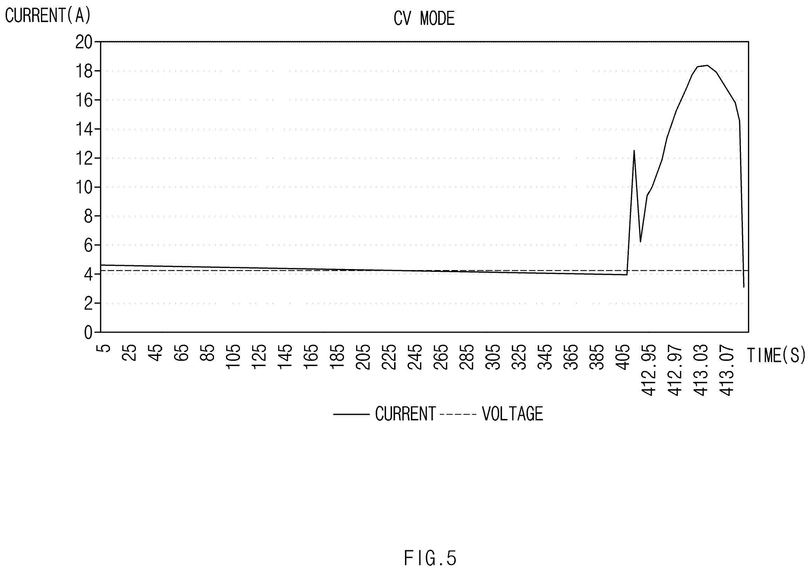

FIG. 5 is a graph showing a method, performed by a battery diagnosis apparatus, of diagnosing a state of a battery based on a current, according to an embodiment disclosed herein.

Referring to FIG. 5, the controller 130 may diagnose the state of the battery 200 based on the current of the battery 200. According to an embodiment, the controller 130 may diagnose the state of the battery 200 by comparing the current of the battery 200 with the preset range. The controller 130 may determine whether the current of the battery 200 falls out of the preset range in the CV mode. When the current of the battery 200 falls out of the preset range, the controller 130 may determine the state of the battery 200 as abnormal. When the current of the battery 200 does not fall out of the preset range, the controller 130 may determine the state of the battery 200 as normal. Herein, the preset range may be set based on a type of the battery 200, a state of the battery 200, etc.

The battery diagnosis apparatus 100 may diagnose the state of the battery 200 based on the change range a of the voltage, the temperature variance, or the current of the battery 200, thereby improving the reliability of state diagnosis of the battery 200. The battery diagnosis apparatus 100 may transmit a notification regarding the battery 200 having a possibility of ignition to a user, thereby preventing the ignition of the battery 200.

The battery diagnosis apparatus 100 may diagnose the state of the battery 200 based on information about one of the voltage, the temperature, and the current of the battery 200, which may be obtained. Thus, equipment for diagnosis of the battery 200 may be minimized and the efficiency of diagnosis of the battery 200 may be improved.

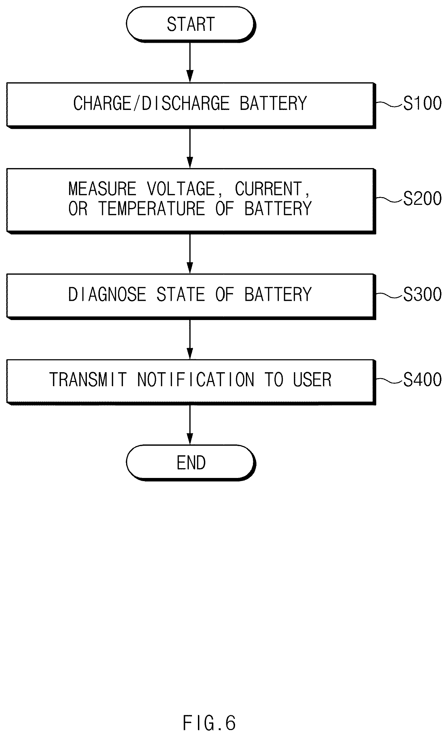

FIG. 6 is a flowchart of a battery diagnosis method according to an embodiment disclosed herein.

The embodiment shown in FIG. 6 may be an example, and an order of operations according to various embodiments of the present disclosure may be different from that shown in FIG. 6, and some operations shown in FIG. 6 may be omitted, the order of the operations may be changed, or the operations may be merged.

Referring to FIG. 6, the operating method may include operation S100 of charging/discharging the battery 200, operation S200 of measuring a voltage, a current, or a temperature of the battery 200, operation S300 of diagnosing a state of the battery 200, and operation S400 of transmitting a notification to the user.

Hereinbelow, operations S100 through S400 will be described in detail with reference to FIGS. 1 to 5.

In operation S100, the battery diagnosis apparatus 100 may charge/discharge the battery 200. According to an embodiment, the battery diagnosis apparatus 100 may charge/discharge the battery 200 in a plurality of modes. For example, the battery diagnosis apparatus 100 may charge/discharge the battery 200 in the CC mode or the CV mode. Herein, the CC mode may be a constant current mode. The CV mode may be a constant voltage mode.

According to an embodiment, the battery diagnosis apparatus 100 may charge/discharge the battery 200 in the CV mode after charging/discharging the battery 200 in the CC mode. That is, the battery diagnosis apparatus 100 may charge/discharge the battery 200 in the CC mode and change the charging/discharging mode from the CC mode to the CV mode. In this case, a point in time at which the CC mode ends may coincide with a point in time at which the CV mode starts.

In operation S200, the battery diagnosis apparatus 100 may measure a voltage, a current, or a temperature of the battery 200. That is, the battery diagnosis apparatus 100 may measure at least one of the voltage, the current, or the temperature of the battery 200. The battery diagnosis apparatus 100 may measure at least one of the voltage, the current, or the temperature of the battery 200 in the CV mode.

In operation S300, the battery diagnosis apparatus 100 may diagnose the state of the battery 200. The battery diagnosis apparatus 100 may diagnose the state of the battery 200 based on the voltage, the temperature, or the current of the battery 200. That is, the battery diagnosis apparatus 100 may determine the state of the battery 200 as normal or abnormal based on the voltage, the temperature, or the current of the battery 200. Herein, the battery 200 in an abnormal state may mean the battery 200 having a possibility of ignition.

In operation S400, the battery diagnosis apparatus 100 may transmit a notification to the user. When the battery diagnosis apparatus 100 determines the state of the battery 200 as abnormal, the controller 130 may provide information about the battery 200 to the user. According to an embodiment, the battery diagnosis apparatus 100 may provide the information about the battery 200 to the user terminal through a communication unit (not shown) and provide the information about the battery 200 through a display provided in a vehicle, a charger, etc.

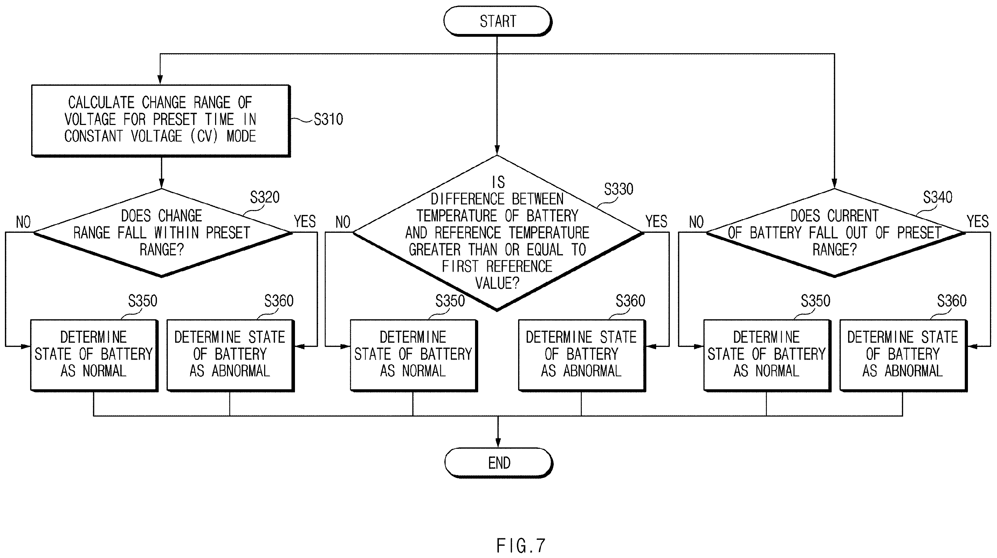

FIG. 7 is a flowchart showing in detail an operation of diagnosing the state of the battery 200 in FIG. 6.

Referring to FIG. 7, the operation of diagnosing the state of the battery 200 may include operation S310 of calculating the change range a of the voltage for a preset time in the CV mode, operation S320 of determining whether the change range a falls within a preset range, operation S330 of determining whether a difference between the temperature of the battery 200 and the reference temperature T1 is greater than or equal to the first reference value, operation S340 of determining whether the current of the battery 200 falls out of a preset range, operation S350 of determining the state of the battery 200 as normal, and operation S360 of determining the state of the battery 200 as abnormal.

In operation S310, the battery diagnosis apparatus 100 may calculate the change range a of the voltage for a preset time in the CV mode. Herein, the preset time may be set based on specifications of the charging/discharging unit 110. For example, when the precision of a voltage or a current applied by the charging/discharging unit 110 to charge the battery 200 is relatively high, the preset time may be set relatively long. When the precision of the voltage or the current applied by the charging/discharging unit 110 to charge the battery 200 is relatively low, the preset time may be set relatively short. The battery diagnosis apparatus 100 may detect the maximum value V1 and the minimum value V2 of the voltage in the preset time. The battery diagnosis apparatus 100 may calculate the difference between the maximum value V1 and the minimum value V2 of the voltage to calculate the change range a of the voltage.

In operation S320, the battery diagnosis apparatus 100 may determine whether the change range a falls within the preset range. The battery diagnosis apparatus 100 may compare the change range a of the voltage with the preset range. Herein, the preset range may be set based on the specifications of the charging/discharging unit 110. For example, when the precision of a voltage or a current applied by the charging/discharging unit 110 to charge the battery 200 is relatively high, the preset range may be set relatively narrow. When the precision of a voltage or a current applied by the charging/discharging unit 110 to charge the battery 200 is relatively low, the preset range may be set relatively broad. According to an embodiment, the width of the preset range may be, but not limited to, 0.00001 V or less.

When the battery diagnosis apparatus 100 determines that the change range a of the voltage falls within the preset range, operation S360 may be performed. When the battery diagnosis apparatus 100 determines that the change range a of the voltage does not fall within the preset range, operation S350 may be performed.

In operation S330, the battery diagnosis apparatus 100 may determine whether the difference between the temperature of the battery 200 and the reference temperature T1 is greater than or equal to the first reference value. First, the controller 100 may set the reference temperature T1. Herein, the reference temperature T1 may be a temperature of the battery 200 at a point in time when the charging mode of the battery 200 switches from the CC mode to the CV mode. That is, the battery diagnosis apparatus 100 may set the temperature of the battery 200 to the reference temperature T1 at a start point of the CV mode.

According to an embodiment, the battery diagnosis apparatus 100 may calculate the difference between the temperature of the battery 200 and the reference temperature T1. The battery diagnosis apparatus 100 may also compare the difference between the temperature of the battery 200 and the reference temperature T1 with a first reference value. Herein, the first reference value may be set based on a type of the battery 200, etc.

When the battery diagnosis apparatus 100 determines that the difference between the temperature of the battery 200 and the reference temperature T1 is greater than or equal to the first reference value, operation S360 may be performed. When the battery diagnosis apparatus 100 determines that the difference between the temperature of the battery 200 and the reference temperature T1 is less than the first reference value, operation S350 may be performed.

In operation S340, the battery diagnosis apparatus 100 may determine that the current of the battery 200 falls out of the preset range.

The battery diagnosis apparatus 100 may diagnose the state of the battery 200 based on the current of the battery 200. According to an embodiment, the battery diagnosis apparatus 100 may diagnose the state of the battery 200 by comparing the current of the battery 200 with the preset range. The battery diagnosis apparatus 100 may determine whether the current of the battery 200 falls out of the preset range in the CV mode. Herein, the preset range may be set based on a type of the battery 200, a state of the battery 200, etc.

When the battery diagnosis apparatus 100 determines that the current of the battery 200 falls out of the preset range, operation S360 may be performed. When the battery diagnosis apparatus 100 determines that the current of the battery 200 does not fall out of the preset range, operation S350 may be performed.

In operation S350, the battery diagnosis apparatus 100 may determine the state of the battery 200 as normal.

In operation S360, the battery diagnosis apparatus 100 may determine the state of the battery 200 as abnormal. Herein, the abnormal state may mean a state in which there is a possibility of the ignition of the battery 200.

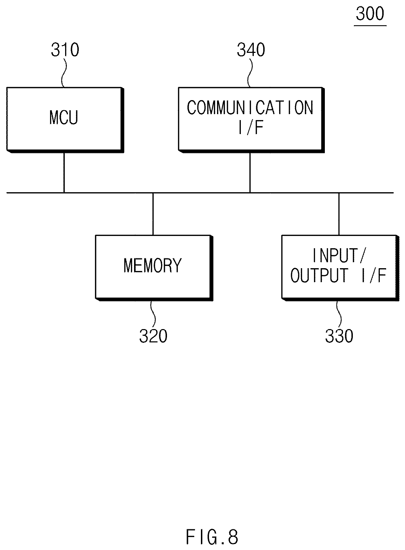

FIG. 8 is a block diagram illustrating a computing system that performs a battery diagnosis method according to an embodiment disclosed herein.

Referring to FIG. 7, a computing system 300 according to an embodiment disclosed herein may include a micro control unit (MCU) 310, a memory 320, an input/output I/F 330, and a communication I/F 340.

The MCU 310 may be a processor that executes various programs (e.g., an SOH calculation program, a cell balancing target determination program, etc.) stored in the memory 320, processes various data including an SOC, an SOH, etc., of the plurality of battery cells through these programs, and executes the above-described functions of the battery diagnosis apparatus 100 described with reference to FIGS. 1 to 5.

The memory 320 may store various programs regarding SOH calculation of the battery cell, cell balancing target determination, etc. Moreover, the memory 320 may store various data such as SOC data, SOH data, etc., of each battery cell.

The memory 320 may be provided in plural, depending on a need. The memory 320 may be volatile memory or non-volatile memory. For the memory 320 as the volatile memory, random access memory (RAM), dynamic RAM (DRAM), static RAM (SRAM), etc., may be used. For the memory 320 as the nonvolatile memory, read only memory (ROM), programmable ROM (PROM), electrically alterable ROM (EAROM), erasable PROM (EPROM), electrically erasable PROM (EEPROM), flash memory, etc., may be used. The above-listed examples of the memory 320 are merely examples and are not limited thereto.

The input/output I/F 330 may provide an interface for transmitting and receiving data by connecting an input device (not shown) such as a keyboard, a mouse, a touch panel, etc., and an output device such as a display (not shown), etc., to the MCU 310.

The communication I/F 340, which is a component capable of transmitting and receiving various data to and from a server, may be various devices capable of supporting wired or wireless communication. For example, a program for SOH calculation of the battery cell or balancing target determination or various data, etc., may be transmitted and received to and from a separately provided external server through the communication I/F 340.

As such, the battery diagnosis method according to an embodiment disclosed herein may be recorded in the memory 320 and executed by the MCU 310.

The above description is merely illustrative of the technical idea of the present disclosure, and various modifications and variations will be possible without departing from the essential characteristics of embodiments of the present disclosure by those of ordinary skill in the art to which the embodiments disclosed herein pertains.

Therefore, the embodiments disclosed herein are intended for description rather than limitation of the technical spirit of the embodiments disclosed herein and the scope of the technical spirit of the present disclosure is not limited by these embodiments disclosed herein. The protection scope of the technical spirit disclosed herein should be interpreted by the following claims, and all technical spirits within the same range should be understood to be included in the range of the present disclosure.

### [Description of Symbols]

10: Battery Inspection System
100: Battery Diagnosis Apparatus
110: Charging/Discharging Unit
120: Information Obtaining Unit
130: Controller
200: Battery

## Claims

1. A battery diagnosis apparatus comprising:
a charging/discharging unit configured to charge/discharge a battery in a constant current (CC) mode or a constant voltage (CV) mode;
an information obtaining unit configured to measure a voltage or a temperature of the battery; and
a controller configured to diagnose a state of the battery based on at least one of a change range of the voltage for a preset time or a temperature variance from a switching point of a charging mode.

2. The battery diagnosis apparatus of claim 1, wherein the controller is further configured to, in the CV mode:
calculate the voltage change range for the preset time; and
determine the state of the battery based on the change range.

3. The battery diagnosis apparatus of claim 2, wherein the controller is further configured to determine the state of the battery as abnormal when the change range falls within a preset range, and
the change range is a difference between a maximum value and a minimum value of the voltage.

4. The battery diagnosis apparatus of claim 3, wherein the preset range is set based on specifications of the charging/discharging unit.

5. The battery diagnosis apparatus of claim 2, wherein the preset time is set based on the specifications of the charging/discharging unit.

6. The battery diagnosis apparatus of claim 1, wherein the controller is further configured to:
compare a reference temperature, which is a temperature at a switching point from the CC mode to the CV mode, with a temperature of the battery; and
determine the state of the battery as abnormal when a difference between the temperature of the battery and the reference temperature is greater than or equal to a first reference value.

7. The battery diagnosis apparatus of claim 6, wherein the controller is further configured to determine the state of the battery as abnormal when the difference between the temperature of the battery and the reference temperature is greater than or equal to a second reference value and a current of the battery rises, and
the second reference value is less than the first reference value.

8. The battery diagnosis apparatus of claim 1, wherein the information obtaining unit is further configured to measure the current of the battery, and
the controller is further configured to:
determine whether the current falls out of a preset range; and
determine the state of the battery as abnormal when the current falls out of the preset range.

9. The battery diagnosis apparatus of claim 1, wherein the controller is further configured to transmit a notification to a user when the state of the battery is abnormal.

10. A battery diagnosis method comprising:
charging/discharging a battery in a constant current (CC) mode or a constant voltage (CV) mode;
measuring a voltage, a current, or a temperature of the battery; and
diagnosing a state of the battery based on at least one of a change range of the voltage for a preset time or a temperature variance from a switching point of a charging mode.

11. The battery diagnosis method of claim 10, wherein the diagnosing of the state of the battery comprises:
calculating the voltage change range for the preset time in the CV mode; and
determining the state of the battery based on the change range.

12. The battery diagnosis method of claim 11, wherein the diagnosing of the state of the battery comprises determining the state of the battery as abnormal when the change range falls within a preset range, and
the change range is a difference between a maximum value and a minimum value of the voltage.

13. The battery diagnosis method of claim 12, wherein the preset range is set based on specifications of a charging/discharging unit.

14. The battery diagnosis method of claim 11, wherein the preset time is set based on the specifications of the charging/discharging unit.

15. The battery diagnosis method of claim 10, wherein the diagnosing of the state of the battery comprises:
comparing a reference temperature, which is a temperature at a switching point from the CC mode to the CV mode, with a temperature of the battery; and
determining the state of the battery as abnormal when a difference between the temperature of the battery and the reference temperature is greater than or equal to a first reference value.

16. The battery diagnosis method of claim 15, wherein the diagnosing of the state of the battery comprises determining the state of the battery as abnormal when the difference between the temperature of the battery and the reference temperature is greater than or equal to a second reference value and a current of the battery rises, and
the second reference value is less than the first reference value.

17. The battery diagnosis method of claim 10, wherein the diagnosing of the state of the battery comprises:
determining whether the current falls out of a preset range; and
determining the state of the battery as abnormal when the current falls out of the preset range.

18. The battery diagnosis method of claim 10, further comprising, after diagnosing the state of the battery, transmitting a notification to a user when the state of the battery is abnormal.
